# EUROPEAN PATENT SPECIFICATION

(11) **EP 3 211 978 B1**
(45) Date of publication and mention of the grant of the patent: **10.10.2018**
(21) Application number: 16157567.5
(22) Date of filing: 26.02.2016
(51) Int. Cl.: H05K 7/14, H05K 7/00

(54) **POWER SUPPLY**
NETZTEIL
ALIMENTATION ELECTRIQUE

(43) Date of publication of application: 30.08.2017
(73) Proprietor: Delta Electronics, Inc., Taoyuan County 32063 (TW)
(72) Inventor: JEN, Yu-Chi, 32063 Taoyuan City (TW)
(74) Representative: 2K Patentanwälte Blasberg Kewitz & Reichel

(56) References cited:
- EP-A2- 1 478 218
- DE-A1-102004 046 251
- US-A- 5 430 608
- US-A1- 2011 143 021
- US-A1- 2014 098 498
- US-B1- 7 042 745

## Description

### BACKGROUND OF THE INVENTION

### Field of the Invention

The present invention is related to a power supply, in particular to a power supply having an insulation connecting plate.

### Description of Related Art

A typical power supply includes a grounding outer casing made of a metal and a conversion module received inside the grounding outer casing in order to convert the voltage of the power source with the conversion module. In general, the conversion module is covered by an insulation film and is isolated as well as insulated from the grounding outer casing. In addition, the conversion module is fastened onto the grounding outer casing and is also grounded onto the grounding outer casing at the same time.

One of the shortcomings of the currently existing technology is that the insulation film must be configured to correspond to the opening hole of the fastening area, causing the creepage distance, as known as the shortest distance between two objects along the insulation surface, between the conversion module and the grounding outer casing to be shortened. In view of the safety required, an electronic component with a higher working voltage shall have a longer creepage distance from the grounding area; therefore, the opening hole would then cause the creepage distance of the area of the conversion module at a higher working voltage to be too short. One of the typical corresponding solutions is to increase the actual distance between the conversion module and the grounding outer casing; however, it would then correspondingly increase the overall volume of the power supply. In addition, another resolution is to reserve a range on the conversion module with the fastening point as a center, and no circuits or electronic components are arranged within such range; however, such solution would lead to a poor utilization rate of the circuit board.

DE 10 2004 046251 A1 discloses a power supply according to the preamble of claim 1. An insulation connecting plate including first and second blind holes formed on the insulation connecting plate and used for coupling the power conversion module and the metal case is not disclosed.

EP 1 478 218 A2 discloses a base assembly for a drive controller wherein multiple electrical connectors are arranged in a connecting plane, at least one plug direction being perpendicular to the connecting plane. An assembly surface on the motor output side is formed from sheet metal which lies on a holding plate in a switch cabinet when the base sub-assembly is mounted.

US 5 430 608 A discloses a portable computer having a body which includes a body housing, and a power supply unit provided within the body housing. The power supply unit includes a metal housing having a plurality of openings and an inner surface. A printed circuit board is provided within the metal housing. An insulating sheet formed of a resin is provided within the metal housing. A metal film is provided within the metal housing and located between the inner surface of the metal housing and the insulating sheet, the metal film closing the openings.

US 7 042 745 B1 discloses a DC-to-AC inverter comprising an inverter housing, a power conversion module, and an interference insulating arrangement. The power conversion module includes a main PCB which has a DC-AC inversion circuitry implemented thereon to convert an input DC signal into an output AC signal. The DC inlet is electrically connected to the main PCB for connecting with a DC power source to draw of a DC current as the input DC signal to the main PCB, wherein the CD inlet is located at the free zone of the receiving compartment to insulate the DC inlet from being electromagnetically interfered during a DC to AC conversion at the power conversion module.

Further related power supply modules are disclosed in US 2011/143021 A1 and US 2014/098498 A1.

### SUMMARY OF THE INVENTION

It is an object of the present invention to provide an enhanced power supply offering an increased creeping distance with a simple, efficient configuration, particularly also offering a high utilization rate.

This problem is solved by a power supply according to claim 1. Further advantageous embodiments are the subject-matter of the dependent claims.
according to the present invention there is provided a power supply comprising a metal case, a power conversion module and an insulation connecting plate. The power conversion module is received inside the metal case and spaced apart from the metal case, and the power conversion module comprises a circuit board. The insulation connecting plate is connected to the circuit board and the metal case respectively, and the insulation connecting plate is arranged to be isolated between at least a portion of the circuit board and at least a portion of the metal case. According to the present invention one side of the insulation connecting plate includes a plurality of first blind holes formed thereon and another side of the insulation connecting plate includes a plurality of second blind holes formed thereon; wherein the power conversion module is fastened onto the plurality of first blind holes, and the metal case is fastened onto the plurality of second blind holes.

The insulation connecting plate is particularly arranged between the high voltage area of the circuit board of the power conversion module and the metal case enabling an increased creepage distance under the premise where the power supply volume is not increased or the utilization rate of the circuit board is not reduced; therefore. Therefore, the power supply according to the present invention can satisfy safety requirements with a simple, efficient configuration.

According to a further embodiment the circuit board comprises a high voltage area, and the insulation connecting plate is connected to the high voltage area. The insulation connecting plate is arranged between the high voltage area and the metal case.

According to a further embodiment the power conversion module is covered by an insulation film in order to isolate and insulate the power conversion module from the metal case. The insulation connecting plate is covered inside the insulation film.

According to a further embodiment one side the insulation connecting plate includes a plurality of first insulation columns formed thereon, each one of the first insulation columns includes a first blind hole formed thereon respectively, and the first blind hole extends longitudinally along the first insulation column; another side of the insulation connecting plate includes a plurality of second insulation columns, each one of the second insulation columns includes a second blind hole formed thereon respectively, and the second blind hole extends longitudinally along the second insulation column; another side of the insulation connecting plate includes a plurality of second blind holes formed thereon; the power conversion module is fastened onto the plurality of first blind holes, and the metal case is fastened onto the plurality of second blind holes. The power conversion module is covered by an insulation film in order to isolate and insulate the power conversion module from the metal case, the insulation film includes at least one opening hole formed thereon and provided to allow the second insulation column to penetrate therethrough in order to fasten onto the metal case. The opening hole is disposed inside an edge of the insulation connecting plate. The first insulation column can protrude to opposite surfaces of the insulation connecting plate. The second insulation column can protrude to opposite surfaces of the insulation connecting plate.

According to a further embodiment an inner side of the metal case includes a protruding column protruded therefrom, and the power conversion module is fastened onto the protruding column. The circuit board comprises a low voltage area, and the low voltage area is fastened onto the plurality of protruding columns. The power conversion module is covered by an insulation film in order to isolate and insulate the power conversion module from the metal case, and the insulation film includes at least one opening hole formed thereon and provided to allow the protruding column to penetrate therethrough in order to fasten onto the power conversion module. Each one of the protruding columns includes a fastening hole formed thereon respectively, and the fastening hole extends longitudinally along the protruding column in order to be provided for fastening onto the power conversion module.

The power supply of the present invention provides an insulation connecting plate arranged between the high voltage area of the circuit board of the power conversion module and the metal case such that it is able to increase the creepage distance under the premise where the power supply volume is not increased or the utilization rate of the circuit board is not reduced; therefore, it is able to satisfy the safety requirements.

### BRIEF DESCRIPTION OF DRAWING

- FIG. 1: is a perspective view of the power supply according to a preferred embodiment of the present invention;
- FIG. 2: is a perspective exploded view of the power supply according to the preferred embodiment of the present invention;
- FIG. 3: is an illustration showing the fastening of the protruding columns in the power supply according to the preferred embodiment of the present invention;
- FIG. 4: is another perspective exploded view of the power supply according to the preferred embodiment of the present invention;
- FIG. 5: is a perspective view of the insulation connecting plate in the power supply according to the preferred embodiment of the present invention;
- FIG. 6: is another perspective view of the insulation connecting plate in the power supply according to the preferred embodiment of the present invention;
- FIG. 7: is a longitudinal cross sectional view of the power supply according to the preferred embodiment of the present invention;
- FIG. 8: is an illustration showing the fastening of the first blind holes in the power supply according to the preferred embodiment of the present invention;
- FIG. 9: is an illustration showing the fastening of the second blind holes in the power supply according to the preferred embodiment of the present invention;
- FIG. 10: is an illustration showing the arrangement of the insulation film in the power supply of the present invention; and
- FIG. 11: is an illustration showing another form of the insulation film in the power supply of the present invention.

### DETAILED DESCRIPTION OF THE INVENTION

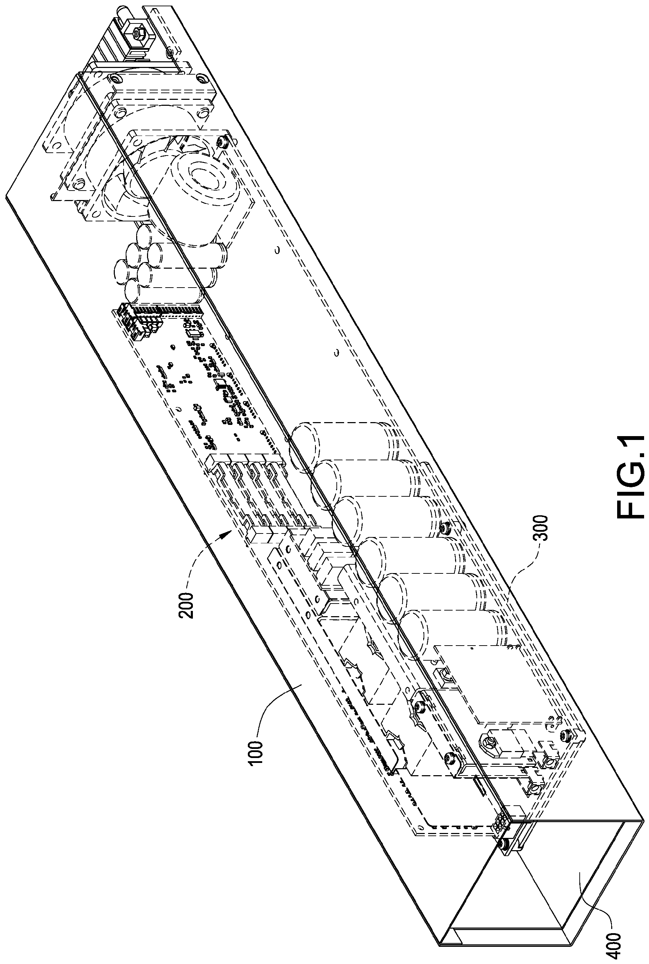

As shown in FIG. 1, a power supply according to a preferred embodiment of the present invention is provided, comprising a metal case 100, a power conversion module 200, an insulation connecting plate 300 and an insulation film 400.

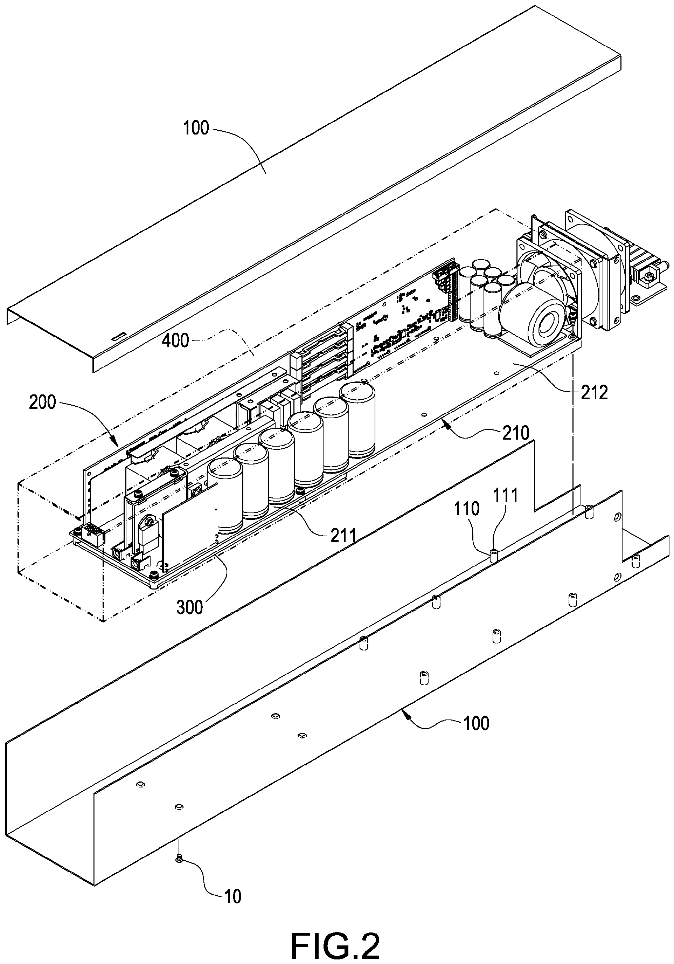

As shown in FIG. 1 and FIG. 2, in this embodiment, the metal case 100 is a rectangular box made of a sheet metal, which can also be constructed by a multiple part assembly. In addition, the inner side of the metal case 100 includes a plurality of protruding columns 110 formed thereon, each one of the protruding columns 110 includes a fastening hole 111 formed thereon respectively and provided for fastening, and the fastening hole 111 extends longitudinally along the protruding column 110. The outer shape of the metal case 100 can be modified dependent upon the needs, and the present invention is not limited to any particular outer shapes of the metal case 100.

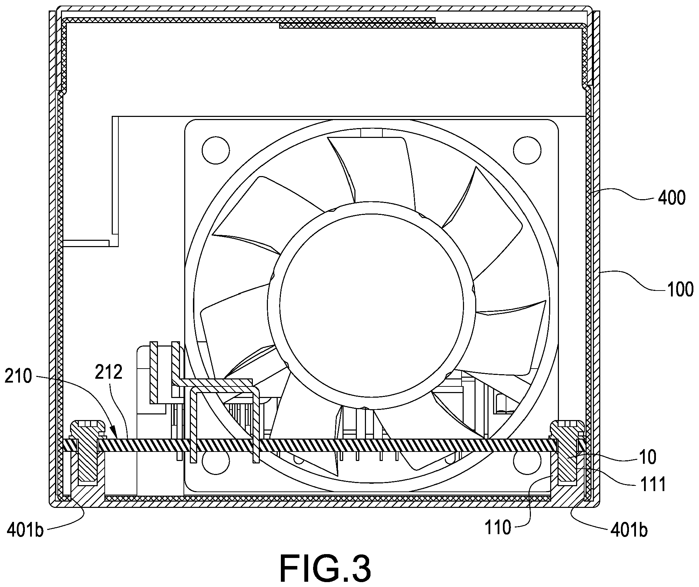

As shown in FIGs 1 to 3, the power conversion module 200 is received inside the metal case 100 and is arranged spaced apart from the metal case 100. In this embodiment, the power conversion module 200 comprises a circuit board 210, and the circuit board 210 comprises a high voltage area 211 and a low voltage area 212. Some electronic components are disposed on the high voltage area 211 and the low voltage area 212 respectively in order to perform the power source voltage conversion via such areas. The low voltage area 212 of the circuit board 210 of the power conversion module 200 uses screws 10 for fastening onto the protruding columns 110 inside the metal case 100 for securement thereof.

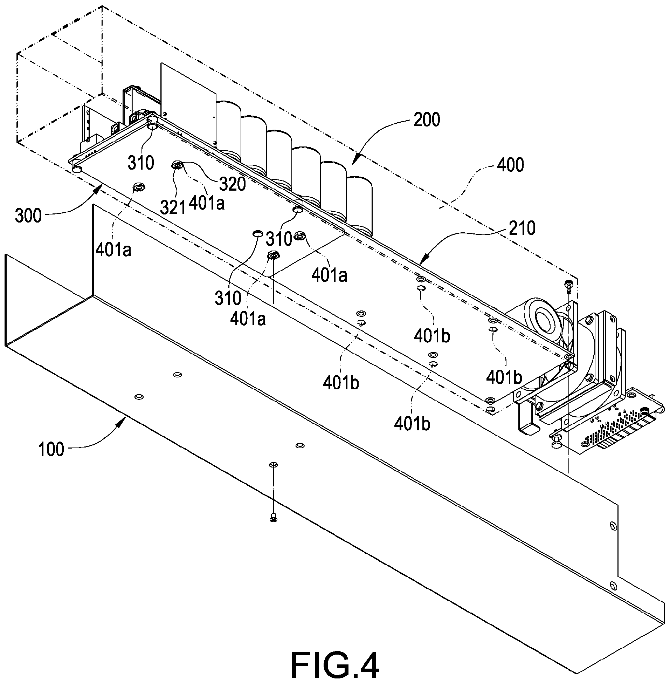

As shown in FIG. 2 and FIG. 4, the insulation connecting plate 300 is connected to the circuit board 210 and the metal case 100 respectively in order to secure the power conversion module 200 inside the metal case 100. In this embodiment, the insulation connecting plate 300 is arranged to isolate between the high voltage area 211 of the circuit board 210 and the metal case 100. In addition, the insulation connecting plate 300 is respectively fastened onto the high voltage area 211 of the circuit board 210 and the metal case 100.

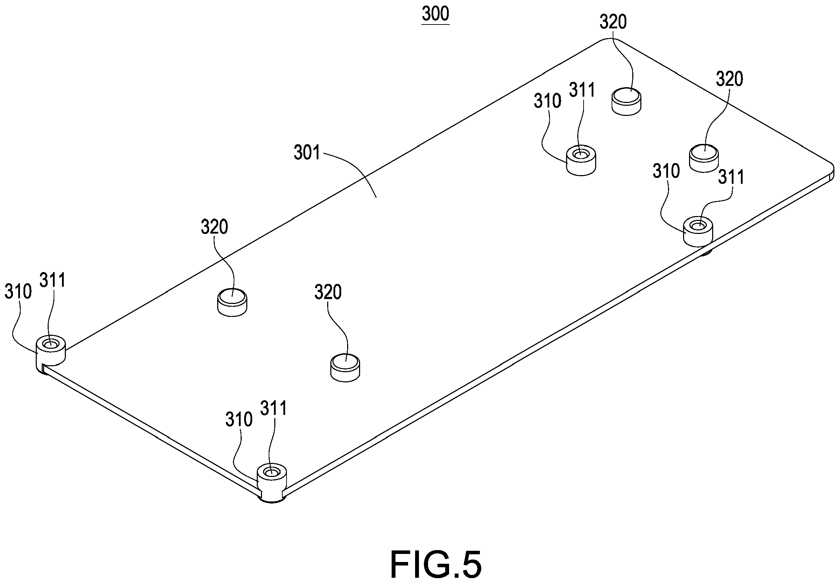

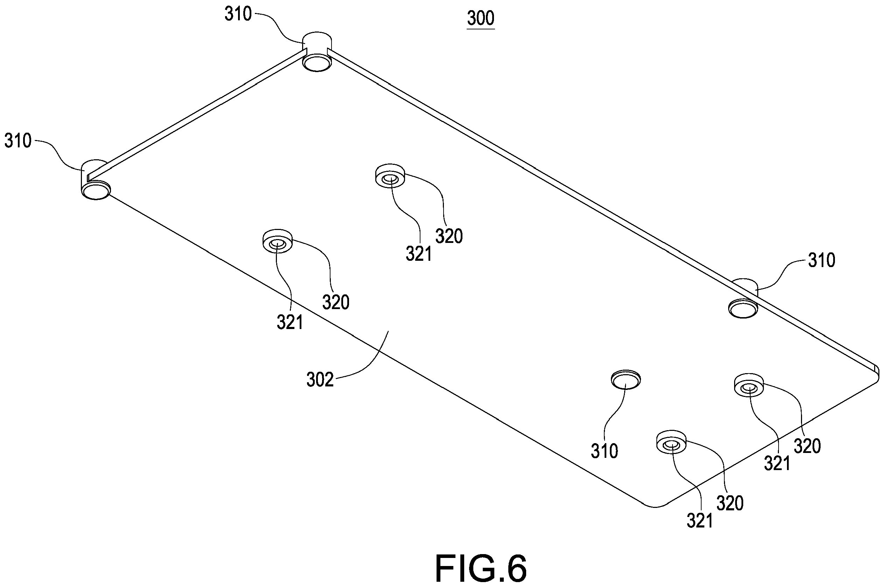

As shown in FIG. 5 and FIG. 6, the connection method adopted to connect the insulation connecting plate 300 with the circuit board 210 and the metal case 100 is described in detail as follows. The two sides of the insulation connecting plate 300 refer to a first surface 301 and a second surface 302 opposite from the first surface 301 respectively. The first surface 301 includes a plurality of first blind holes 311 formed thereon, and the second surface 302 includes a plurality of blind holes 321 formed thereon. Preferably, the first surface 301 includes a plurality of first insulation columns 310 protruded therefrom, and the first blind holes 311 are formed on each one of the first insulation columns 310 respectively. In addition, each one of the first blind holes 311 extends longitudinally along the first insulation column 310. The second surface 302 includes a plurality of second insulation columns 320 protruded therefrom, and the second blind holes 321 are formed on each one of the second insulation columns 320 respectively. In addition, each one of the second blind holes 321 extends longitudinally along the second insulation column 320.

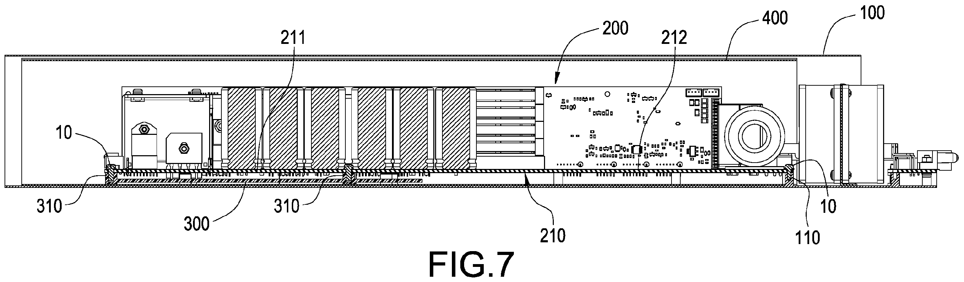

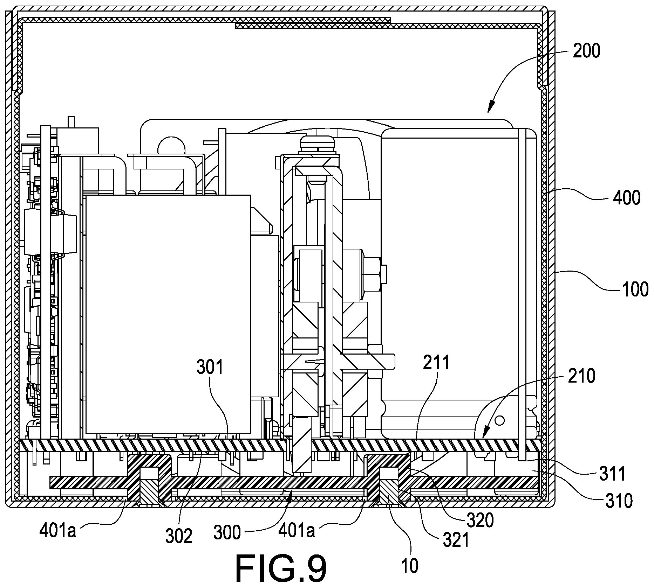

As shown in FIG. 7 and FIG. 9, the high voltage area 211 of the circuit board 210 uses the screws 10 for fastening onto the first blind holes 311 for securement thereof, and the metal case 100 uses the screws 10 for fastening onto the second blind holes 321 for securement thereof such that the power conversion module 200 is secured inside the metal case 100. The first insulation column 310 and the second insulation column 320 must have sufficient lengths in order to be provided for fastening; preferably, the first insulation column 310 can protrude to the second surface 302 of the insulation connecting plate 300, and the second insulation column 320 can also protrude to the first surface 301 of the insulation connecting plate 300; therefore, the overall thickness of the insulation connecting plate 300 can be reduced.

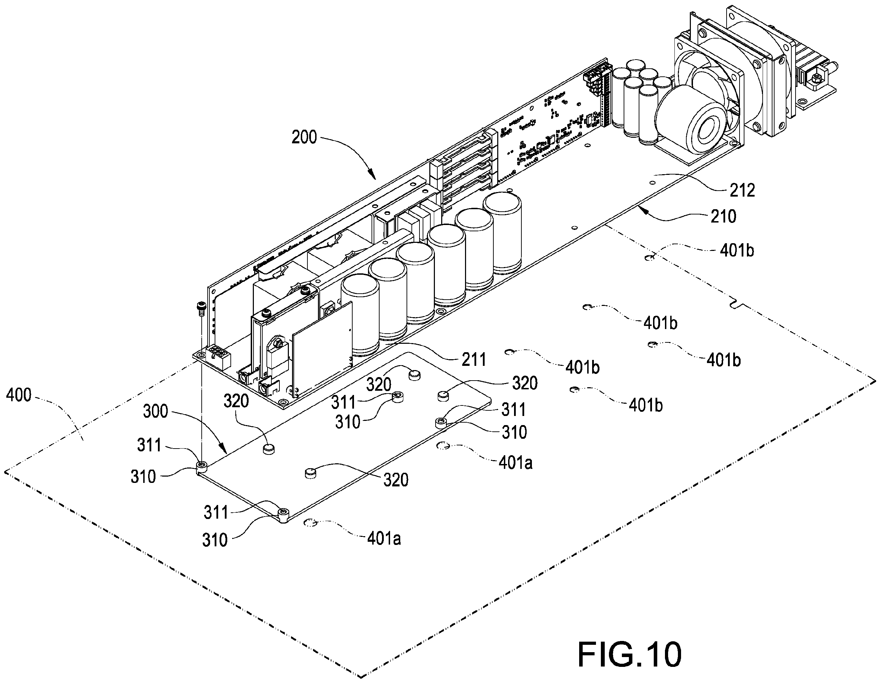

As shown in FIG. 2, FIG. 4 and FIG. 10, the insulation film 400 is made of an insulative paper. The insulation film 400 is folded to cover the power conversion module 200 in order to isolate and insulate the power conversion module 200 from the metal case 100.

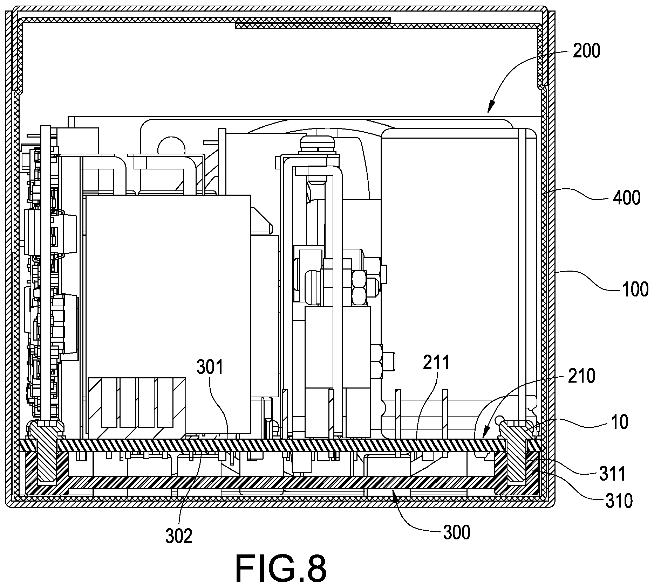

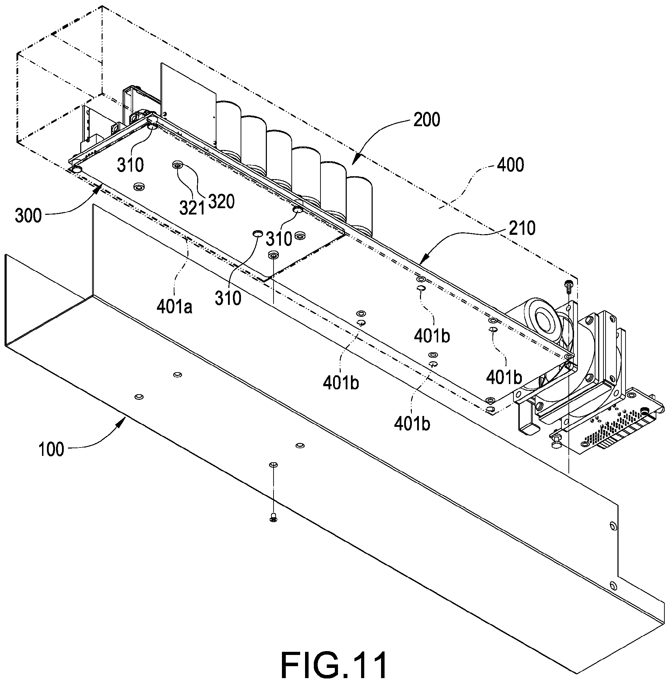

As shown in FIG. 7 to FIG. 10, in this embodiment, the insulation film 400 includes a plurality of opening holes 401a, 401b formed thereon. A portion of the opening holes 401a is disposed inside the edge of the insulation connecting plate 300, and each one of the opening holes 401a is respectively provided to allow the corresponding second insulation column 320 to penetrate therethrough in order to fasten onto the metal case 100. In this embodiment, the insulation connecting plate 300 is covered inside the insulation film 400; however, it can also be configured in such a way, as shown in FIG. 11, a greater opening hole 401a is formed to allow a multiple of second insulation columns 320 to penetrate therethrough in order to fasten onto the metal case 100. When an opening hole 401a is formed to have a dimension identical to that of the insulation connecting plate 300, then the insulation connecting plate 300 is not covered by the insulation film 400. Another portion of the opening holes 401b is disposed outside the edge of the insulation connecting plate 300 and are provided to allow the protruding column 110 to penetrate therethrough in order to fasten onto the low voltage area 212 of the circuit board 210 of the power conversion module 200.

The power supply of the present invention provides the insulation connecting plate 300 arranged between the high voltage area of the circuit board 210 of the power conversion module 200 and the metal case 100 in order to increase the creepage distance between the high voltage area 211 and the metal case 100 without increasing the volume of the power supply as well as without reducing the utilization rate of the circuit board 210.

## Claims

1. A power supply, comprising:
a metal case (100),
a power conversion module (200) received inside the metal case (100) and spaced apart from the metal case (100), the power conversion module (200) comprising a circuit board (210); and
an insulation connecting plate (300) connected to the circuit board (210) and the metal case (100) respectively, the insulation connecting plate (300) being isolated between at least a portion of the circuit board (210) and at least a portion of the metal case (100);
**characterized in that** one side of the insulation connecting plate (300) includes a plurality of first blind holes (311) formed thereon;
another side of the insulation connecting plate (300) includes a plurality of second blind holes (321) formed thereon; wherein
the power conversion module (200) is fastened onto the plurality of first blind holes (311), and
the metal case (100) is fastened onto the plurality of second blind holes (321).

2. The power supply according to claim 1, wherein the circuit board (210) comprises a high voltage area (211), and the insulation connecting plate (300) is connected to the high voltage area (211).

3. The power supply according to claim 2, wherein the insulation connecting plate (300) is arranged between the high voltage area (211) and the metal case (100).

4. The power supply according to any of the preceding claims, wherein the power conversion module (200) is covered by an insulation film (400) in order to isolate and insulate the power conversion module (200) from the metal case (100).

5. The power supply according to Claim 4, wherein the insulation connecting plate (300) is covered inside the insulation film (400).

6. The power supply according to any of the preceding claims, wherein
one side the insulation connecting plate (300) includes a plurality of first insulation columns (310) formed thereon, each one of the first insulation columns (310) includes a first blind hole (311) formed thereon, and the first blind hole (311) extends longitudinally along the first insulation column (310);
another side of the insulation connecting plate (300) includes a plurality of second insulation columns (320), each one of the second insulation columns (320) includes a second blind hole (321) formed thereon respectively, and the second blind hole (321) extends longitudinally along the second insulation column (320);
the power conversion module (200) is fastened onto the plurality of first blind holes (311), and
the metal case (100) is fastened onto the plurality of second blind holes (321).

7. The power supply according to Claim 6, wherein the power conversion module (200) is covered by an insulation film (400) in order to isolate and insulate the power conversion module (200) from the metal case (100), the insulation film (400) includes at least one opening hole (401a) formed thereon and provided to allow the second insulation columns (320) to penetrate therethrough in order to fasten onto the metal case (100).

8. The power supply according to Claim 7, wherein the opening hole (401a) is disposed inside an edge of the insulation connecting plate (300).

9. The power supply according to any of claims 6 to 8, wherein the first insulation column (310) protrudes to opposite surfaces of the insulation connecting plate (300).

10. The power supply according to any of claims 6 to 9, wherein the second insulation column (320) protrudes to opposite surfaces of the insulation connecting plate (300).

11. The power supply according to any of the preceding claims, wherein an inner side of the metal case (100) includes a protruding column (110) protruded therefrom, and the power conversion module (200) is fastened onto the protruding column (110).

12. The power supply according to claim 11, wherein the circuit board (210) comprises a low voltage area (212) and the low voltage area (212) is fastened onto the plurality of protruding columns (110).

13. The power supply according to claim 11 or 12, wherein the power conversion module (200) is covered by an insulation film (400) in order to isolate and insulate the power conversion module (200) from the metal case (100), and the insulation film (400) includes at least one opening hole (401b) formed thereon and provided to allow the protruding column (110) to penetrate therethrough in order to fasten onto the power conversion module (200).

14. The power supply according to any of claims 11 to 13, wherein each one of the protruding columns (110) includes a fastening hole (111) formed thereon respectively, and the fastening hole (111) extends longitudinally along the protruding column (110) in order to be provided for fastening onto the power conversion module (200).

## Patentansprüche

1. Stromversorgung, umfassend:
ein Metallgehäuse (100),
ein Spannungswandlungs-Modul (200), das innerhalb des Metallgehäuses (100) aufgenommen und von dem Metallgehäuse (100) beabstandet ist, wobei das Spannungswandlungs-Modul (200) eine Leiterplatte (210) umfasst; und
eine Isolierverbindungsplatte (300), die mit der Leiterplatte (210) bzw. dem Metallgehäuse (100) verbunden ist, wobei die Isolierverbindungsplatte (300) zwischen zumindest einem Abschnitt der Leiterplatte (210) und zumindest einem Abschnitt des Metallgehäuses (100) isoliert ist;
**dadurch gekennzeichnet, dass** eine Seite der Isolierverbindungsplatte (300) eine Mehrzahl von darauf ausgebildeten ersten Sacklöchern (311) aufweist;
eine andere Seite der Isolierverbindungsplatte (300) eine Mehrzahl von darauf ausgebildeten zweiten Sacklöchern (321) aufweist; wobei
das Spannungswandlungs-Modul (200) an den mehreren ersten Sacklöchern (311) befestigt ist und
das Metallgehäuse (100) an den mehreren zweiten Sacklöchern (321) befestigt ist.

2. Stromversorgung nach Anspruch 1, wobei die Leiterplatte (210) einen Hochspannungsbereich (211) aufweist und die Isolierverbindungsplatte (300) mit dem Hochspannungsbereich (211) verbunden ist.

3. Stromversorgung nach Anspruch 2, wobei die Isolierverbindungsplatte (300) zwischen dem Hochspannungsbereich (211) und dem Metallgehäuse (100) angeordnet ist.

4. Stromversorgung nach einem der vorhergehenden Ansprüche, wobei das Spannungswandlungs-Modul (200) durch eine Isolationsschicht (400) abgedeckt ist, um das Spannungswandlungs-Modul (200) von dem Metallgehäuse (100) zu trennen und elektrisch zu isolieren.

5. Stromversorgung nach Anspruch 4, wobei die Isolierverbindungsplatte (300) innerhalb der Isolationsschicht (400) abgedeckt ist.

6. Stromversorgung nach einem der vorhergehenden Ansprüche, wobei
eine Seite die Isolierverbindungsplatte (300) eine Mehrzahl von darauf ausgebildeten ersten Isolationssäulen (310) aufweist, jede der ersten Isolationssäulen (310) ein darauf ausgebildetes erstes Sackloch (311) aufweist und das erste Sackloch (311) sich entlang der ersten Isolationssäule (310) erstreckt;
eine andere Seite der Isolierverbindungsplatte (300) eine Mehrzahl von zweiten Isolationssäulen (320) aufweist, jede der zweiten Isolationssäulen (320) jeweils ein darauf ausgebildetes zweites Sackloch (321) aufweist und das zweite Sackloch (321) sich entlang der zweiten Isolationssäule (320) erstreckt;
das Spannungswandlungs-Modul (200) an den mehreren ersten Sacklöchern (311) befestigt ist und
das Metallgehäuse (100) an den mehreren zweiten Sacklöchern (321) befestigt ist.

7. Stromversorgung nach Anspruch 6, wobei das Spannungswandlungs-Modul (200) durch eine Isolationsschicht (400) abgedeckt ist, um das Spannungswandlungs-Modul (200) von dem Metallgehäuse (100) zu trennen und elektrisch zu isolieren, wobei die Isolationsschicht (400) mindestens ein darauf ausgebildetes Öffnungsloch (401a) aufweist, das vorgesehen ist, sodass sich die zweiten Isolationssäulen (320) durch dieses hindurch erstrecken können, zur Befestigung auf dem Metallgehäuse (100).

8. Stromversorgung nach Anspruch 7, wobei das Öffnungsloch (401a) innerhalb eines Rands der Isolierverbindungsplatte (300) angeordnet ist.

9. Stromversorgung nach einem der Ansprüche 6 bis 8, wobei die erste Isoliersäule (310) zu gegenüberliegenden Oberflächen der Isolierverbindungsplatte (300) vorsteht.

10. Stromversorgung nach einem der Ansprüche 6 bis 9, wobei die zweite Isoliersäule (320) zu gegenüberliegenden Oberflächen der Isolierverbindungsplatte (300) vorsteht.

11. Stromversorgung nach einem der vorhergehenden Ansprüche, wobei eine Innenseite des Metallgehäuses (100) eine davon vorstehende Säule (110) aufweist und das Spannungswandlungs-Modul (200) an der vorstehenden Säule (110) befestigt ist.

12. Stromversorgung nach Anspruch 11, wobei die Leiterplatte (210) einen Niederspannungsbereich (212) aufweist und der Niederspannungsbereich (212) an den mehreren vorstehenden Säulen (110) befestigt ist.

13. Stromversorgung nach Anspruch 11 oder 12, wobei das Spannungswandlungs-Modul (200) durch eine Isolationsschicht (400) abgedeckt ist, um das Spannungswandlungs-Modul (200) von dem Metallgehäuse (100) zu trennen und elektrisch zu isolieren, und wobei die Isolationsschicht (400) mindestens ein darauf ausgebildetes Öffnungsloch (401b) aufweist, das vorgesehen ist, sodass die vorstehende Säule (110) sich durch dieses hindurch erstrecken kann, zur Befestigung an dem Spannungswandlungs-Modul (200).

14. Stromversorgung nach einem der Ansprüche 11 bis 13, wobei jede der vorstehenden Säulen (110) jeweils ein darauf ausgebildetes Befestigungsloch (111) aufweist und sich das Befestigungsloch (111) längs der vorstehenden Säule (110) erstreckt, um zur Befestigung an dem Spannungswandlungs-Modul (200) vorgesehen zu sein.

## Revendications

1. Une alimentation électrique comprenant:
un boîtier métallique (100),
un module de conversion de puissance (200) logé à l'intérieur du boîtier métallique (100) et espacé du boîtier métallique (100), le module de conversion de puissance (200) comprenant une carte de circuit imprimé (210) ; et
une plaque de connexion d'isolation (300) connectée respectivement à la carte de circuit imprimé (210) et au boîtier métallique (100), la plaque de connexion d'isolation (300) étant isolée entre au moins une partie de la carte de circuit imprimé (210) et au moins une partie du boîtier métallique (100)
**caractérisée en ce qu'**un côté de la plaque de connexion d'isolation (300) comporte une pluralité de premiers trous borgnes (311) formés sur celle-ci ;
un autre coté de la plaque de connexion d'isolation (300) comporte une pluralité de second trous borgnes (321) formés sur celle-ci ; dans laquelle
le module de conversion de puissance (200) est fixé sur la pluralité de premier trous borgnes (311), et
le boîtier métallique (100) est fixé sur la pluralité de second trous borgnes (321).

2. L'alimentation électrique selon la revendication 1, dans laquelle la carte de circuit imprimé (210) comprend une zone haute tension (211), et la plaque de connexion d'isolation (300) est connectée à la zone haute tension (211).

3. L'alimentation électrique selon la revendication 2, dans laquelle la plaque de connexion d'isolation (300) est disposée entre la zone haute tension (211) et le boîtier métallique (100).

4. L'alimentation électrique selon l'une quelconque des revendications précédentes, dans laquelle le module de conversion de puissance (200) est recouvert par un film isolant (400) afin d'isoler et d'isoler le module de conversion de puissance (200) du boîtier métallique (100).

5. L'alimentation électrique selon la revendication 4, dans laquelle la plaque de connexion d'isolation (300) est recouverte à l'intérieur du film isolant (400).

6. L'alimentation électrique selon l'une quelconque des revendications précédentes, dans laquelle
un côté de la plaque de connexion d'isolation (300) comprend une pluralité de premières colonnes d'isolation (310) formées sur celle-ci, chacune des premières colonnes d'isolation (310) comprenant un premier trou borgne (311) formé dessus, et le premier trou borgne (311) s'étendant longitudinalement le long de la première colonne d'isolation (310);
un autre côté de la plaque de connexion d'isolation (300) comprend une pluralité de secondes colonnes d'isolation (320), chacune des secondes colonnes d'isolation (320) comprenant un second trou borgne (321) formé respectivement dessus, et le second trou borgne (321)) s'étendant longitudinalement le long de la seconde colonne d'isolation (320);
le module de conversion de puissance (200) est fixé sur la pluralité de premiers trous borgnes (311), et
le boîtier métallique (100) est fixé sur la pluralité de seconds trous borgnes (321).

7. L'alimentation électrique selon la revendication 6, dans laquelle le module de conversion de puissance (200) est recouvert par un film isolant (400) afin d'isoler le module de conversion de puissance (200) du boîtier métallique (100), le film isolant (400) comprenant au moins un trou d'ouverture (401a) formé sur celui-ci et prévu pour permettre aux secondes colonnes d'isolation (320) de les traverser afin de se fixer sur le boîtier métallique (100).

8. L'alimentation électrique selon la revendication 7, dans laquelle le trou d'ouverture (401a) est disposé à l'intérieur d'un bord de la plaque de connexion d'isolation (300).

9. L'alimentation électrique selon l'une quelconque des revendications 6 à 8, dans laquelle la première colonne d'isolation (310) fait saillie sur des surfaces opposées de la plaque de connexion d'isolation (300).

10. L'alimentation électrique selon l'une quelconque des revendications 6 à 9, dans laquelle la seconde colonne d'isolation (320) fait saillie sur des surfaces opposées de la plaque de connexion d'isolation (300).

11. Une alimentation électrique selon l'une quelconque des revendications précédentes, dans lequel un côté interne du boîtier métallique (100) comprend une colonne en saillie (110) en saillie et le module de conversion de puissance (200) est fixé sur la colonne en saillie (110).

12. L'alimentation électrique selon la revendication 11, dans laquelle la carte de circuit imprimé (210) comprend une zone basse tension (212) et la zone basse tension (212) est fixée sur la pluralité de colonnes saillantes (110).

13. L'alimentation électrique selon la revendication 11 ou 12, dans laquelle le module de conversion de puissance (200) est recouvert par un film isolant (400) afin d'isoler le module de conversion de puissance (200) du boîtier métallique (100), et un film isolant (400) comprend au moins un trou d'ouverture (401b) formé sur celui-ci et prévu pour permettre à la colonne en saillie (110) d'y pénétrer afin de se fixer sur le module de conversion de puissance (200).

14. L'alimentation électrique selon l'une quelconque des revendications 11 à 13, dans laquelle chacune des colonnes en saillie (110) comprend un trou de fixation (111) formé respectivement sur celle-ci et le trou de fixation (111) s'étend longitudinalement le long de la colonne en saillie (110), pour la fixation sur le module de conversion de puissance (200).
